# EUROPÄISCHE PATENTSCHRIFT

(11) **EP 2 594 122 B1**
(45) Veröffentlichungstag und Bekanntmachung des Hinweises auf die Patenterteilung: **14.06.2017**
(21) Anmeldenummer: 11730005.3
(22) Anmeldetag: 07.07.2011
(51) Int. Cl.: H05K 5/06, F02M 37/08, F04D 13/06, H02K 5/12, H02K 5/00, H02K 11/00

(54) **GEHÄUSE EINER ELEKTRONISCHEN SCHALTUNG FÜR EINE KRAFTSTOFFPUMPE**
HOUSING FOR AN ELECTRONIC CIRCUIT FOR A FUEL PUMP
BOÎTIER DE CIRCUIT ÉLECTRONIQUE POUR UNE POMPE À CARBURANT

(30) Priorität: 12.07.2010 DE 102010026953
(43) Veröffentlichungstag der Anmeldung: 22.05.2013
(73) Patentinhaber: Continental Automotive GmbH, 30165 Hannover (DE)
(72) Erfinder: GRAF, Rolf, 61479 Glashütten (DE)
(86) Internationale Anmeldenummer: PCT/EP2011/061518
(87) Internationale Veröffentlichungsnummer: WO 2012/007348

(56) Entgegenhaltungen:
- WO-A1-2007/031455
- FR-A1- 2 908 696
- US-A- 4 998 865
- US-A1- 2009 183 715

## Beschreibung

Gegenstand der Erfindung ist ein Gehäuse einer elektronischen Schaltung für eine Kraftstoffpumpe, bestehend aus einer Leiterplatte, auf der Leiterplatte angeordnete elektrische und/oder elektronische Bauelemente, einem Boden und einem mit dem Boden verbundenen Deckel, wobei Boden und Deckel das Gehäuse bilden.

Derartige elektronische Schaltungen kommen in Kraftstoffpumpen von Kraftfahrzeugen zum Einsatz, um Kraftstoff aus einem Kraftstoffbehälter zu einer Brennkraftmaschine zu fördern. Die elektronische Schaltung wird benötigt, um den elektronisch geregelten Elektromotor der Kraftstoffpumpe zu betreiben. Die dabei verwendeten Leiterplatten bestehen in der Regel aus faserverstärktem Kunststoff, wobei als Kunststoffe Epoxide aber auch Duro- und Thermoplaste oder spezielle Kunststoffe wie PTFE Verwendung finden. Als Fasermaterialien kommen Glasfasern, Kunststoff- und Kohlefasern sowie Pflanzenfasern und Papier zum Einsatz. Infolge der Anordnung der elektronischen Schaltung in der Kraftstoffpumpe oder in deren unmittelbarer Umgebung müssen die elektronischen Bauteile und Leiterbahnen vor den aggressiven Bestandteilen des Kraftstoffs geschützt werden. Da Kraftstoffbestandteile auch durch Leiterplatten diffundieren, bietet diese keinen ausreichenden Schutz. Daher wird zum Schutz der elektronischen Schaltung die Leiterplatte mit den Bauelementen innerhalb eines dichten Metallgehäuses angeordnet, wie dies z. B. aus der US 4 998 865 A und der FR 2 908 696 A1 bekannt ist. Die Durchführungen für die elektrischen Anschlüsse sind als Glas-Metall-Durchführungen auszubilden. Der Nachteil dieser Glas-Metall-Durchführungen besteht im Aufwand und den Kosten zur Herstellung der Abdichtung.

Es ist weiter bekannt, Bauelemente auf einem Keramikboden anzuordnen und den Keramikboden mit einem Metalldeckel zu verlöten, so dass die Bauelemente zwischen Keramikboden und Deckel geschützt angeordnet sind. Der Keramikboden wirkt dabei als Diffusionssperre für den Kraftstoff.

Nachteilig bei beiden Ausgestaltungen ist der erhebliche Kostenfaktor derartiger Gehäuse, der einen wirtschaftlichen Einsatz ausschließlich bei hochwertigen Anwendungen zulässt.

Der Erfindung liegt daher die Aufgabe zugrunde, ein Gehäuse einer elektronischen Schaltung zu schaffen, deren Bauelemente ausreichend vor Kraftstoff geschützt sind. Der Schutz der elektronischen Schaltung soll dabei in kostengünstiger Weise erreicht werden.

Erfindungsgemäß wird die Aufgabe mit den Merkmalen des Anspruchs 1 gelöst.

Hierbei wird der Umstand genutzt, dass sowohl Leiterplatten als auch elektronische Bauelemente eine gewisse Beständigkeit gegenüber aggressiven Bestandteilen, wie sie in Kraftstoffen enthalten sind, besitzen. Mit dem zu schaffenden Gehäuse muss daher keine absolute Sperrwirkung erzielt werden, was wiederum nur mit einem hermetisch dichten Gehäuse möglich wäre. Vielmehr wird die bereits vorhandene Beständigkeit der Leiterplatte und der Bauelemente mit der Sperrwirkung des erfindungsgemäßen Gehäuses zusammengeführt, um einen ausreichenden Schutz der elektronischen Schaltung zu gewährleisten. Mit der Anordnung der vergleichsweise kostengünstigen Deckel zu beiden Seiten der Leiterplatte wird bereits ein Großteil der Schutzwirkung erreicht, die es ermöglicht, eine vollständige Kapselung der Leiterplatte zu vermeiden. Das Gehäuse kann somit einfacher und kostengünstiger gestaltet werden.

Mit dem Vorsehen eines zweiten Deckels wird zudem die Möglichkeit eröffnet, auf dieser Seite der Leiterplatte ebenfalls eine elektrische oder elektronische Schaltung anzuordnen, beziehungsweise die Schaltung zu beiden Seiten der Leiterplatte anzuordnen. Dadurch können die Abmessungen der Leiterplatte reduziert und Gewicht sowie wertvoller Bauraum eingespart werden.

Eine sichere und ausreichende Verbindung der Deckel mit der Leiterplatte wird dadurch erreicht, dass in zumindest den Bereichen der Leiterplatte, in denen die Deckel aufliegen, jeweils eine in sich geschlossene metallische Bahn angeordnet ist, und dass die Deckel mit der jeweiligen Bahn mittels einer Lötverbindung verbunden sind.

Die metallischen Bahnen zum Befestigen der Deckel lassen sich besonders einfach herstellen, wenn sie aus dem Material der Leiterbahnen, vorzugsweise aus Kupfer oder Gold, bestehen. So können die metallischen Bahnen mit denselben Verfahren und Vorrichtungen erzeugt werden, welche zum Aufbringen der Leiterbahnen genutzt werden.

Zur Erhöhung der Sperrwirkung trägt es bei, wenn die Breite der geschlossenen, metallischen Bahnen größer als der Bereich des Deckels ist, der über die Lötverbindung mit der Leiterplatte verbunden ist. Die Breite der metallischen Bahn ist ein Maß für die Sperrwirkung, da die metallische Bahn wie auch die Sperrlage als Diffusionssperre wirken. Insofern verlängert sich mit zunehmender Breite der metallischen Bahn der Diffusionsweg im Isolationsmaterial der Leiterplatte, wodurch sich die Schutzwirkung erhöht.

Um die Sperrwirkung der Deckel nicht zu beeinträchtigen, sieht eine weitere Ausgestaltung vor, die Kontaktierung der Schaltung und deren Bauelemente mit von außen herangeführten elektrischen Leitungen durch in die Leiterplatte eingebettete Anschlussleitungen vorzunehmen. Hierzu sind auf der Leiterplatte angeordnete Kontakte vorgesehen, welche mit den in der Leiterplatte eingebetteten Anschlussleitungen verbunden sind. Damit wird vermieden, dass die Deckel für die Kontaktierung unterbrochen werden, was eine Reduzierung der Sperrwirkung zur Folge hätte. Die Anschlussleitungen können als eine oder mehrere Leiterebenen ausgebildet sein, welche voneinander isoliert, übereinander in der Leiterplatte angeordnet sind.

Eine Beeinträchtigung der Sperrwirkung wird zudem dadurch vermieden, dass die Kontakte außerhalb der metallischen Bahnen auf der Leiterplatte angeordnet sind. Zu diesem Zweck ist es auch denkbar, die Leiterplatte partiell vergrößert auszubilden.

Die aufgrund der Kontaktanordnung ungeschützten Bereiche der Leiterplatte lassen sich reduzieren, wenn die Kontakte innerhalb der metallischen Bahnen, jedoch außerhalb der Deckel angeordnet sind, wobei die metallischen Bahnen die Kontakte mit einem als Ringspalt ausgebildeten Abstand umgeben.

Die Diffusion von Kraftstoff über den äußeren Rand, welcher den Umfang der Leiterplatte bildet, wird mit einer Sperrlage verhindert, wobei diese Sperrlage derart am Umfang der Leiterplatte angeordnet ist, dass sie die metallischen Bahnen zu beiden Seiten der Leiterplatte miteinander verbindet.

An mehreren Ausführungsbeispielen wird die Erfindung näher erläutert. Es zeigen in
- Figur 1:: die Leiterplatte eines erfindungsgemäßen Gehäuses,
- Figur 2:: eine Schnittdarstellung des erfindungsgemäßen Gehäuses aus Figur 1,
- Figur 3:: eine zweite Ausführungsform der Leiterplatte nach Figur 1 und
- Figur 4, 5:: weitere Ausführungsformen des Gehäuses nach Figur 2.

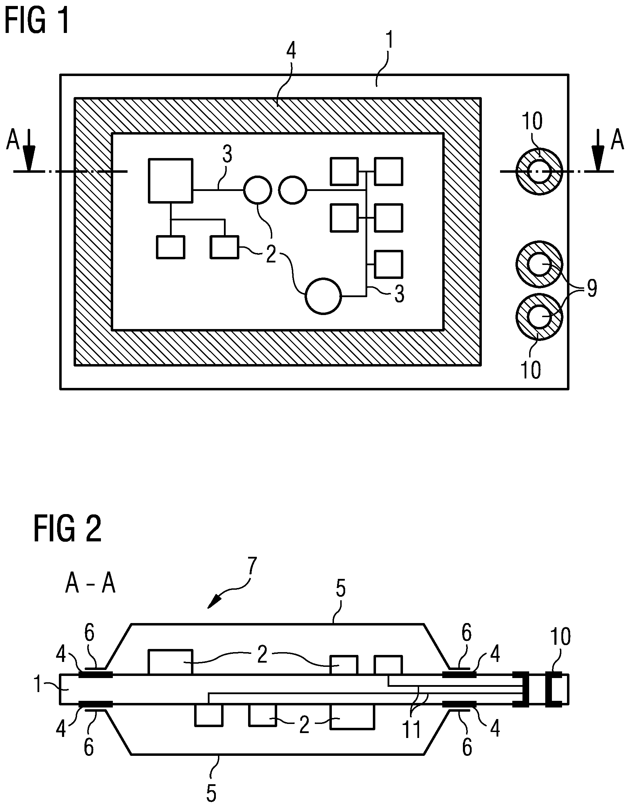

Figur 1 zeigt eine Leiterplatte 1 in einer Draufsicht, wobei zur besseren Darstellung kein Deckel gezeichnet ist. Auf der Leiterplatte 1 sind elektronische Bauelemente 2 einer elektronischen Schaltung angeordnet, welche über Leiterbahnen 3 miteinander verschaltet sind. Im Randbereich der Leiterplatte ist eine in sich geschlossene metallische Bahn 4 angeordnet, welche die elektronische Schaltung umgibt. Die in sich geschlossene metallische Bahn 4 besteht wie die Leiterbahnen 3 aus Kupfer. Die Leiterplatte 1 besteht aus einem Kunstharz auf Epoxidbasis. An einer Seite weist die Leiterplatte 1 außerhalb der in sich geschlossenen metallischen Bahn 4 mehrere Durchbrüche 9 auf, die mit Kupfer ausgekleidet sind. Die Durchbrüche 9 bilden Kontakte 10 zum Anschluss der elektronischen Schaltung an entsprechende elektrische Anschlussleitungen, die hier nicht dargestellt sind.

In Figur 2 zeigt die Leiterplatte 1 im Schnitt. Die elektronische Schaltung mit den Bauelementen 2 ist sowohl auf der Ober- und der Unterseite der Leiterplatte 1 innerhalb der jeweiligen in sich geschlossenen metallischen Bahn 4 angeordnet. Auf den metallischen Bahnen 4 ist jeweils ein Deckel 5 aus Metall aufgelötet, der die elektronische Schaltung mit den Bauelementen 2 vollständig abdeckt. Die Ränder 6 der Deckel 5 sind flanschartig nach außen gerichtet, um eine gute Auflagefläche für die Verbindung mit der Leiterplatte 1 zu erhalten. Die Leiterplatte 1 und die Deckel 5 bilden damit das Gehäuse 7. Die Deckel 5 schützen dabei die elektronische Schaltung vor dem direkten Kontakt mit Kraftstoff. Lediglich der ungeschützte umlaufende Rand der Leiterplatte 1 ist jetzt noch dem Kontakt mit Kraftstoff oder Kraftstoffdämpfen ausgesetzt. Damit kann Kraftstoff nur noch zwischen den metallischen Bahnen 4 durch das Leiterplattenmaterial in den von den Deckeln 5 abgedeckten Raum gelangen. Die Breite der metallischen Bahnen 4 bestimmt somit die Länge des Leiterplattenmaterials, durch das der Kraftstoff diffundieren muss, bis die Bauelemente 2 erreicht sind. Daher kann mit einer Verbreiterung der metallischen Bahnen 4 die Sperrwirkung noch weiter verbessert werden.

In der Leiterplatte 1 sind als Anschlussleitung wirkende Leiterebenen 11 angeordnet. Die Leiterebenen 11 verbinden die Bauelemente 2 der elektronischen Schaltung zu beiden Seiten der Leiterplatte 1 mit den jeweiligen Kontakten 10.

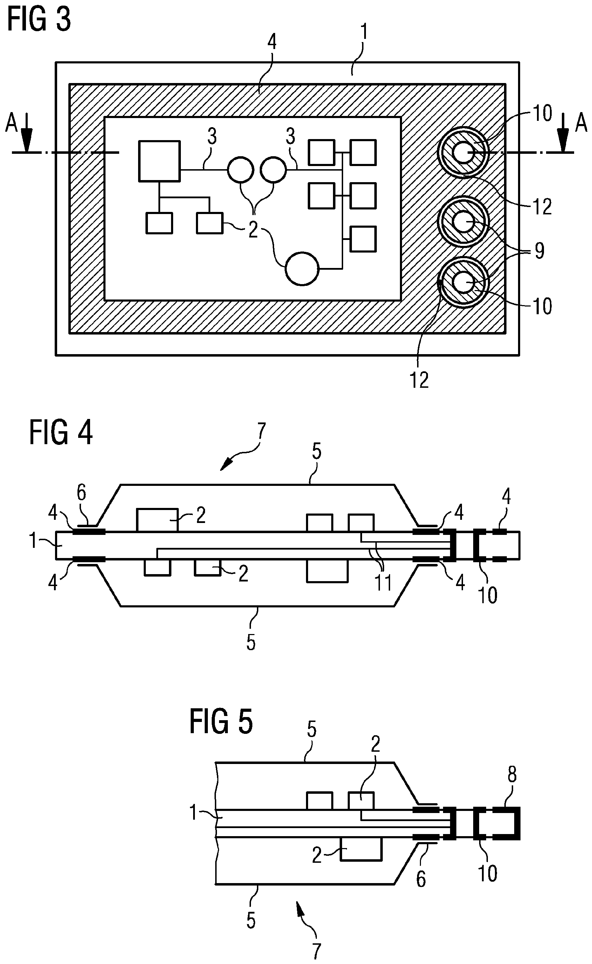

Die in den Figuren 3 und 4 dargestellte Leiterplatte 1 zeichnet sich durch veränderte metallische Bahnen 4 aus. Diese sind soweit verbreitet, dass sie die Kontakte 10 vollständig umschließen. Lediglich ein schmaler Ringspalt 12 um jeden Kontakt 10 gewährleistet die elektrische Trennung von Kontakt 10 und metallischer Bahn 4. Mit dieser Ausgestaltung wird ein noch weiter verbesserter Schutz erreicht.

Bei der Leiterplatte 1 in Figur 5 ist der bisher freiliegende umlaufende Rand mit einer Sperrlage 8 in Form einer Kupferschicht versehen, wobei die Sperrlage 8 die metallischen Bahnen 4 zu beiden Seiten der Leiterplatte 1 verbindet, so dass die Oberfläche der Leiterplatte 1 lediglich im Bereich der Ringspalte 12 frei liegt.

## Patentansprüche

1. Gehäuse einer elektronischen Schaltung für eine Kraftstoffpumpe, bestehend aus einem Boden und einem mit dem Boden verbundenen Deckel (5), einer Leiterplatte (1), die den Boden bildet, einem zweiten Deckel (5), der auf der gegenüberliegenden Seite der Leiterplatte (1) mit dieser verbunden ist, mit zu beiden Seiten der Leiterplatte (1) angeordneten elektrischen und/oder elektronischen Bauelementen (2) ,wobei jedes Bauelement (2) in einem von einem Deckel (5) überdeckten Bereich angeordnet ist und die Deckel (5) aus Metall bestehen, und wobei in zumindest den Bereichen der Leiterplatte (1), in denen die Deckel (5) aufliegen, jeweils eine in sich geschlossene metallische Bahn (4) angeordnet ist, und die Deckel (5) mit der jeweiligen Bahn (4) mittels einer Lötverbindung verbunden sind.

2. Gehäuse nach Anspruch1, **dadurch gekennzeichnet, dass** die metallischen Bahnen (4) aus dem Material der Leiterbahnen, mit denen die Bauelemente (2) miteinander verbunden sind, vorzugsweise aus Kupfer oder Gold, bestehen.

3. Gehäuse nach einem der Ansprüche 1 oder 2, **da** - **durch gekennzeichnet,** dass die Breite der metallischen Bahnen (4) größer als der Bereich des Deckels (5) ist, der über die Lötverbindung mit der Leiterplatte (1) verbunden ist.

4. Gehäuse nach zumindest einem der vorhergehenden Ansprüche, **dadurch gekennzeichnet, dass** die Leiterplatte (1) Kontakte (10) aufweist, welche mit zumindest jeweils einem Bauelement (2) elektrisch leitend verbunden sind, wobei die Verbindung der Bauelemente (2) mit den Kontakten (10) durch in die Leiterplatte (1) eingebettete Anschlussleitungen (11) erfolgt.

5. Gehäuse nach Anspruch 4, **dadurch gekennzeichnet, dass** die Kontakte (10) außerhalb der metallischen Bahnen (4) auf der Leiterplatte (1) angeordnet sind.

6. Gehäuse nach Anspruch 4, **dadurch gekennzeichnet, dass** die Kontakte (10) innerhalb der metallischen Bahnen (4) jedoch außerhalb der Deckel (5) angeordnet sind, wobei die metallischen Bahnen (4) die Kontakte (10) mit einem als Ringspalt (12) ausgebildeten Abstand umgeben.

7. Gehäuse nach zumindest einem der vorhergehenden Ansprüche, **dadurch gekennzeichnet, dass** am Umfang der Leiterplatte (1) eine Sperrlage (8) angeordnet ist, welche die metallischen Bahnen (4) zu beiden Seiten der Leiterplatte (1) verbindet.

## Claims

1. Housing of an electronic circuit for a fuel pump, composed of a base and a cover (5) which is connected to the base, a printed circuit board (1) which forms the base, a second cover (5) which is connected to the printed circuit board (1) on the opposite side thereof, with electric and/or electronic components (2) which are arranged on both sides of the printed circuit board (1), wherein each component (2) is arranged in a region covered by a cover (5) and the covers (5) are composed of metal, and wherein in each case an enclosed metallic track (4) is arranged in at least the regions of the printed circuit board (1) in which the covers (5) bear, and the covers (5) are connected to the respective track (4) by means of a soldered connection.

2. Housing according to Claim 1, **characterized in that** the metallic tracks (4) are composed of the material of the conductor tracks with which the components (2) are connected to one another, preferably of copper or gold.

3. Housing according to either of Claims 1 and 2, **characterized in that** the width of the metallic tracks (4) is greater than the region of the cover (5) which is connected to the printed circuit board (1) via the soldered connection.

4. Housing according to at least one of the preceding claims, **characterized in that** the printed circuit board (1) has contacts (10) which can be electrically conductively connected to at least one component (2) in each case, wherein the connection of the components (2) to the contacts (10) is made by means of connecting lines (11) which are embedded in the printed circuit board (1).

5. Housing according to Claim 4, **characterized in that** the contacts (10) are arranged outside the metallic tracks (4) on the printed circuit board (1).

6. Housing according to Claim 4, **characterized in that** the contacts (10) are arranged inside the metallic tracks (4) but outside the covers (5), wherein the metallic tracks (4) surround the contacts (10) at a distance which is embodied as an annular gap (12).

7. Housing according to at least one of the preceding claims, **characterized in that** a blocking layer (8), which connects the metallic tracks (4) to both sides of the printed circuit board (1), is arranged on the periphery of the printed circuit board (1).

## Revendications

1. Boîtier d'un circuit électronique destiné à une pompe à carburant, constitué d'un fond et d'un couvercle (5) relié au fond, d'une carte de circuit imprimé (1) qui forme le fond, d'un deuxième couvercle (5) qui est relié à celui-ci sur le côté opposé de la carte de circuit imprimé (1), comportant des composants (2) électriques et/ou électronique disposés sur les deux côtés de la carte de circuit imprimé (1), dans lequel chaque composant (2) est disposé dans une zone recouverte par un couvercle (5) et les couvercles (5) sont constitués de métal, et dans lequel une piste métallique (4) respective fermée est disposée au moins dans les zones de la carte de circuit imprimé (1) dans lesquelles sont montés les couvercles (5), et les couvercles (5) sont reliés à la piste (4) respective au moyen d'une liaison par soudure.

2. Boîtier selon la revendication 1, **caractérisé en ce que** les pistes métalliques (4) sont constituées du matériau des pistes conductrices au moyen desquelles les composants (2) sont reliés les uns aux autres, de préférence de cuivre ou d'or.

3. Boîtier selon l'une quelconque des revendications 1 ou 2, **caractérisé en ce que** la largeur des pistes métalliques (4) est supérieure à la zone du couvercle (5) qui est relié à la carte de circuit imprimé (1) par la liaison par soudure.

4. Boîtier selon au moins l'une des revendications précédentes, **caractérisé en ce que** la carte de circuit imprimé (1) comporte des contacts (10) qui sont électriquement reliés respectivement à au moins un composant (2), dans lequel la liaison des composants (2) aux contacts (10) s'effectue par l'intermédiaire de lignes de raccordement (11) intégrées à la carte de circuit imprimé (1).

5. Boîtier selon la revendication 4, **caractérisé en ce que** les contacts (10) sont disposés sur la carte de circuit imprimé (1) à l'extérieur des pistes métalliques (4).

6. Boîtier selon la revendication 4, **caractérisé en ce que** les contacts (10) sont disposés à l'intérieur des pistes métalliques (4) mais à l'extérieur du couvercle (5), dans lequel les pistes métalliques (4) entourent les contacts (10) à une distance définie sous la forme d'un interstice annulaire (12).

7. Boîtier selon au moins l'une des revendications précédentes, **caractérisé en ce qu'**une couche d'arrêt (8) est disposée à la périphérie de la carte de circuit imprimé (1), laquelle couche d'arrêt relie les pistes métalliques (4) aux deux côtés de la carte de circuit imprimé (1).
